# DEMANDE DE BREVET EUROPEEN

(11) **EP 1 168 621 A1**
(43) Date de publication de la demande: **02.01.2002**
(21) Numéro de dépôt: 01401727.1
(22) Date de dépôt: 28.06.2001
(51) Int. Cl.: H03K 17/693

(54) **Circuit intégré avec dispositif de protection**

(30) Priorité: 30.06.2000 FR 0008546
(71) Demandeur: STMicroelectronics S.A., 92120 Montrouge (FR)
(72) Inventeur: Fournel, Richard, 94230 Cachan (FR)
(74) Mandataire: Ballot, Paul

(57) **Abrégé**

Dans un circuit intégré 1 recevant comme tensions d'alimentation, une tension de référence de masse Gnd, une tension d'alimentation logique Vdd, et une haute tension HV, on prévoit un dispositif de protection 2 associé à au moins un élément de circuit, à oxyde de grille, pour appliquer sur un noeud N d'alimentation dudit élément, soit la tension d'alimentation logique Vdd, dans des conditions normales de fonctionnement du circuit intégré, soit la haute tension HV, dans des conditions anormales de fonctionnement du circuit intégré, pour claquer l'oxyde de grille.

## Description

La présente invention concerne un circuit intégré comprenant un dispositif de protection.

De nombreuses applications utilisent des données qui doivent rester secrètes. C'est le cas notamment des cartes à puce ou des circuits de codage ou cryptage de données, qui contiennent des codes confidentiels, clefs de cryptage ou autres. Ces données secrètes sont généralement contenues dans des mémoires non volatiles programmables, par exemple, en mémoire EEPROM, EPROM, ou flash EPROM.

Pour ces applications, il est vital d'empêcher l'accès à ces données, en toutes circonstances.

Or les possibilités d'agressions sont nombreuses. Notamment, il existe une méthode de prédiction utilisant l'analyse statistique basée sur la consommation en courant du circuit, qui permet de reconstituer bit à bit au moins certaines données confidentielles. Il existe aussi des méthodes plus directes, telles l'inspection optique après dépassivation du circuit intégré, la modification de conditions de fonctionnement (température, tensions d'alimentation par exemple)....

Aussi, les circuits intégrés contenant de telles données secrètes comprennent-ils généralement toute une panoplie de capteurs associés à un dispositif de protection des conditions de fonctionnement du circuit intégré, pour générer un signal d'alarme, dès lors qu'une anomalie est détectée. Une anomalie peut être une variation anormale de la température ambiante, de la luminosité (dépassivation du circuit intégré), un niveau anormal d'une tension d'alimentation, plusieurs tentatives d'écriture ou de lecture avortées..... Cette liste n'est pas exhaustive.

Lorsqu'un signal d'alarme est généré, ce signal est généralement utilisé pour interrompre l'opération en cours et ré-initialiser le circuit intégré. On connaît en outre depuis longtemps des circuits de masquage de codage, des circuits de protection d'accès et des procédures logicielles sécurisées pour protéger l'accès aux données secrètes.

Un objet de l'invention est d'améliorer la protection des données secrètes dans un circuit intégré qui reçoit sur des broches externes d'alimentation, la tension de référence de masse, la tension d'alimentation logique et une haute tension normalement utilisée pour la programmation des éléments de mémoire non volatile.

L'idée à la base de l'invention est d'utiliser la haute tension disponible pour détruire tout ou partie de la circuiterie logique du circuit intégré, en sorte qu'il devienne inutilisable de quelque façon que ce soit. Le radicalisme de la destruction du circuit intégré rend impossible de connaître le contenu du circuit intégré et les données secrètes ne peuvent pas être connues.

Dans les technologies MOS récentes, submicroniques, les oxydes de grille sont de l'ordre de 32 angströms en 0,18 microns. Ils ne supportent donc pas plus de 1,8 volts à leurs bornes. L'application brutale de la haute tension sur ces oxydes entraîne la destruction irrémédiable de l'oxyde de grille. C'est cette caractéristique qui est utilisée dans l'invention.

Ainsi, selon l'invention, l'activation du signal d'alarme entraîne l'application de la haute tension sur des éléments de la circuiterie logique, à la place de la tension d'alimentation logique. Les oxydes de grille de ces éléments sont alors irrémédiablement détruits. En pratique ces éléments logiques sont choisis pour que leur destruction rende inutilisable le circuit intégré. Ce peut être tout le circuit intégré ou seulement une partie de ce circuit, comme le microprocesseur, la logique de sélection d'adresse, les registres d'entrée/sortie de données ....

Un dispositif de protection selon l'invention comprend deux commutateurs de tension, pour commuter l'un la haute tension, l'autre la tension d'alimentation logique, sur un noeud d'entrée d'alimentation d'au moins un élément logique du circuit intégré.

Ces commutateurs sont commandés de façon complémentaire par un translateur de niveaux de tension, connecté entre la haute tension et la masse. Ce translateur est commandé par le signal d'alarme généré en interne par le circuit intégré. Tant que ce signal d'alarme n'est pas activé, c'est la tension d'alimentation logique qui est appliquée comme tension d'alimentation de ces éléments logiques. Dès que ce signal d'alarme est activé, c'est la haute tension qui est commutée sur le noeud d'entrée d'alimentation de ces éléments logiques, entraînant leur destruction irrémédiable par claquage des oxydes de grille.

Telle que caractérisée, l'invention concerne donc un circuit intégré avec comme tensions d'alimentation, une tension de référence de masse, au moins une tension d'alimentation logique et une haute tension. Selon l'invention, le circuit intégré comprend en outre un dispositif de protection associé à au moins un élément de circuit, à oxyde de grille, pour appliquer sur un noeud d'alimentation dudit élément, soit la tension d'alimentation logique, dans des conditions normales de fonctionnement du circuit intégré, soit la haute tension, dans des conditions anormales de fonctionnement du circuit intégré, pour claquer l'oxyde de grille.

D'autres caractéristiques et avantages de l'invention sont détaillés dans la description suivante, faite à titre indicatif et non limitatif de l'invention et en référence aux dessins annexés dans lesquels :
- la figure 1 représente un schéma-bloc d'un circuit intégré en technologie submicronique comprenant un dispositif de protection selon l'invention ;
- les figures 2 et 3 représentent chacune un schéma détaillé d'un mode de réalisation d'un dispositif de protection selon l'invention ; et
- la figure 4 est un schéma bloc de moyens de détection de conditions anormales de fonctionnement.

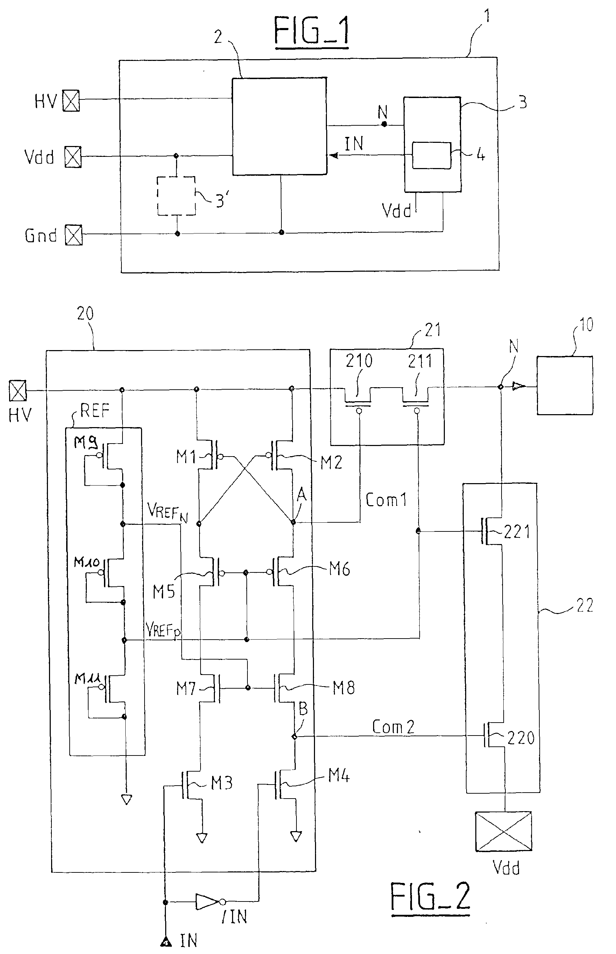

Sur la figure 1, on a représenté de façon schématique un circuit intégré 1 en technologie submicronique, dont l'alimentation de la circuiterie logique 3 est contrôlée par un dispositif de protection 2 selon l'invention. N étant le noeud d'entrée d'alimentation de cette circuiterie, ce noeud reçoit normalement la tension d'alimentation logique Vdd. Par le dispositif de protection 2 selon l'invention, ce noeud est porté à la haute tension dans le cas d'une détection de conditions anormales de fonctionnement du circuit intégré.

Plus précisément, le circuit intégré 1 reçoit sur des broches externes, la masse Gnd, une tension d'alimentation logique Vdd. Une haute tension HV peut être soit fournie en interne, au moyen d'une pompe de charges par exemple, soit reçue sur une broche externe, comme représenté sur la figure.

Les tensions de masse Gnd et Vdd sont habituellement appliquées directement à la circuiterie logique 3 du circuit intégré. La haute tension HV est utilisée pour permettre la programmation d'éléments de mémoire non volatile, de type EEPROM par exemple, non représentés. Dans le cas des circuits intégré basse tension qui nous intéressent tout particulièrement ici, pour lesquels la haute tension est de 5 volts, cette haute tension est aussi utilisée pour réaliser des interfaces avec des circuit externes de technologies 5 volts.

La circuiterie logique du circuit intégré qui peut comprendre par exemple, un microprocesseur, de la mémoire ROM, RAM, comprend en outre des moyens 4 de détection de conditions anormales de fonctionnement du circuit intégré. Ces moyens de détection sont notamment associés à différents capteurs ou détecteurs logiciels. Ces moyens de détection fournissent en sortie un signal d'alarme noté IN sur la figure 1. Dans l'exemple représenté sur la figure 1, ce signal est directement appliqué au dispositif de protection 2. On notera en pratique que c'est généralement le microprocesseur qui active ce signal d'alarme, après vérification des capteurs et analyse des données reçues de ces capteurs ou détecteurs logiciels, en fonction de différents critères de sécurité. Ces techniques sont largement connues et employées depuis longtemps, notamment dans les circuits intégré destinés aux applications de carte à puce.

On notera qu'en pratique, il n'est pas nécessaire de détruire toute la circuiterie logique. On peut ainsi prévoir qu'une partie de la circuiterie logique n'est pas affectée, et reçoit toujours la tension d'alimentation logique Vdd. Il suffit que le noeud N d'alimentation contrôlé par le dispositif de protection selon l'invention sert à l'alimentation d'au moins un élément logique, vital pour le circuit intégré, en sorte que sa destruction rende le circuit intégré absolument inutilisable. On a ainsi représenté en pointillé une partie 3' de la circuiterie logique alimentée directement par la tension d'alimentation logique reçue sur la broche correspondante du circuit intégré. Les moyens de détection 4 peuvent indifféremment être dans la partie 3 ou la partie 3' de la circuiterie logique.

Ce type de claquage réparti dans plusieurs zones du circuit intégré rend impossible la remise en état du circuit intégré, ce qui ne serait pas le cas si on se contentait par exemple, de claquer des fusibles.

Un exemple de réalisation d'un dispositif de protection selon l'invention est représenté sur la figure 2.

Dans cet exemple, le dispositif 2 de protection selon l'invention comprend deux commutateurs 21 et 22. Un premier commutateur 21 est connecté entre la haute tension HV et le noeud N d'alimentation d'au moins un élément 10 de la circuiterie logique. Un deuxième commutateur 22 est connecté entre la tension d'alimentation logique Vdd et le noeud N d'alimentation.

Les deux commutateurs 21 et 22 sont commandés par des moyens 20 de façon complémentaire, en sorte qu'un seul soit fermé à un moment donné, pour appliquer la tension associée sur le noeud N. d'alimentation.

Les moyens 20 sont en pratique un translateur de niveaux apte à fournir en sortie les signaux de commutation des commutateurs 21 et 22.

Ce translateur 20 est commandé par le signal binaire de commande IN. Il est alimenté entre la haute tension HV et la masse Gnd. Comme il doit supporter en permanence la haute tension HV, ce translateur doit comporter un étage de protection à au moins un étage cascode, ou bien comporter des éléments capables de supporter la haute tension, comme par exemple, des transistors MOS à extension de drain, ou de type "drift", ou des transistors MOS à oxyde épais, par exemple de 120 angströms. Cet étage de protection permet de limiter à des niveaux de tension intermédiaires les noeuds internes du translateur, en sorte qu'aucun transistor du translateur ne voit une trop haute tension à ses bornes. Par abus de langage, on appelle les transistors de cet étage de protection, des transistors cascodes.

Ainsi, dans l'exemple représenté, le translateur comprend deux branches, avec dans chaque branche, quatre transistors connectés en série entre la haute tension HV et la masse : un transistor de charge connecté à la haute tension, un transistor de commutation connecté à la masse et commandé par le signal binaire de commande (ou son inverse) et deux transistors cascodes, un pour protéger le transistor de charge, un autre pour protéger le transistor de commutation. Le translateur en outre un circuit REF de génération des tensions de référence V_{REF_{N}} et V_{REF_{P}} des transistors cascodes.

Dans un exemple de réalisation en technologie CMOS correspondant à la représentation de la figure 2, les transistors de commutation du translateur 20 sont de type N. Ils ont leurs sources connectées à la masse. Les transistors de charge sont de type P. Ils ont chacun leur source connectée à la haute tension HV et leur grille connectée au drain du transistor de charge de l'autre branche.

Dans la première branche, on a ainsi, en série entre la haute tension HV et la masse Gnd : un transistor de charge M1 de type P, un transistor cascode M5 de type P, un transistor cascode M7, de type N et un transistor de commutation M3, de type N. Dans l'autre branche, on a, de manière similaire : un transistor de charge M2 de type P, un transistor cascode M6 de type P, un transistor cascode M8 de type N et un transistor de commutation M4 de type N.

Le circuit R_{EF} associé aux transistors cascodes, permet de générer les tensions de référence V_{REF_{N}} et V_{REFₚ}, pour commander les grilles des transistors cascode respectivement de type N et de type P. Dans l'exemple de réalisation de ce circuit représenté sur la figure 2, ce circuit REF est un diviseur résistif, qui comprend trois transistors Mos M9, M10, M11 en série entre la haute tension HV et la masse. Ces trois transistors fonctionnent en résistance puisqu'ils ont chacun leur grille reliée à leur drain. Dans l'exemple, ils sont de type P. Les tensions de référence V_{REFₙ} et V_{REFₚ} sont obtenues en prenant la tension de part et d'autre du transistor du milieu M10.

Avec ces tensions de référence, chaque transistor cascode limite l'excursion de tension sur ses bornes.

Ainsi la source de chaque transistor cascode de type P ne peut pas descendre en dessous de V_{REF_{P}} + Vtₚ, où Vtₚ est la tension de seuil du transistor cascode de type P.

De même, la source de chaque transistor cascode de type N ne peut pas monter au-dessus de V_{REFₙ} - Vtₙ, où Vtₙ est la tension de seuil du transistor cascode de type N.

On a a vu que le translateur 20 doit fournir les signaux de commutation nécessaires, pour commuter de façon complémentaire les commutateurs 21 et 22. Pour cela, ces signaux de commutation doivent avoir leurs niveaux hauts et bas tels que la tension à commuter, le soit sans perte, et que le commutateur à l'état ouvert n'ait pas de fuites de courant.

Un premier signal de commutation com1 est obtenu dans une branche du translateur, entre le transistor de charge connecté à la haute tension, et le transistor cascode suivant, soit dans l'exemple, entre les transistors M2 et M6. Le niveau de ce signal de commutation com1 est soit celui de la haute tension HV, soit un niveau inférieur (V_{REF_{P}} + Vtₚ), imposé par le transistor cascode M6 et fonction de la tension de référence cascode V_{REF_{P}}.

Un deuxième signal de commutation com2 est obtenu dans une branche du translateur, entre le transistor de commutation connecté à la masse Gnd, et le transistor cascode précédent, soit dans l'exemple, entre les transistors M4 et M8. Le niveau de ce signal de commutation com2 est soit celui de masse, soit un niveau supérieur V_{REFₙ} - Vtₙ, qui doit être supérieur à Vdd + Vtₙ.

Ces deux signaux de commutation com1 et com2 permettent de commander de façon complémentaire les deux commutateurs 21 et 22.

Dans l'exemple, le commutateur 21 comprend deux transistors MOS de type P M210 et M211 connectés en série entre la haute tension HV et le noeud N d'alimentation. Le transistor M210 reçoit sur sa grille le premier signal de commutation com1. C'est lui qui permet de commuter la haute tension HV sur le noeud N d'alimentation, tandis que le deuxième transistor M211 agit comme transistor cascode et protège le transistor M210. De même, le commutateur 22 comprend deux transistors MOS de type P M220 et M221 connectés en série entre la tension d'alimentation logique et le noeud N d'alimentation. Le transistor M220 reçoit sur sa grille le deuxième signal de commutation com2. C'est lui qui permet de commuter la tension d'alimentation Vdd sur le noeud N d'alimentation, tandis que le deuxième transistor M221 agit comme transistor cascode et protège le transistor M220.

On notera que la présence des transistors cascodes dans les commutateurs est fonction de la différence de niveau entre la haute tension HV et la tension d'alimentation logique Vdd. En effet, dans le cas où la haute tension HV est de 5 volts et la tension d'alimentation logique Vdd de 1,8 volts (correspondant à une épaisseur d'oxyde de 35 angströms), la différence entre ces deux tensions est de 3,2 volts, soit un niveau que ne peut supporter l'oxyde de grille d'un transistor comme le transistor 210 dans la technologie considérée. Mais si on considère une technologie submicronique à 55 ou 70 angströms d'épaisseur d'oxyde, la tension d'alimentation logique Vdd est plus élevée, de l'ordre de 3,3 volts. Dans ce cas, la différence de tension est inférieure à la tension d'alimentation logique, et les transistors cascodes ne sont plus nécessaire dans les commutateurs. De même, si les transistors du commutateur sont du type à oxyde plus épais (120 angströms). Dans ce cas, le transistor de commutation de la tension Vdd peut être directement commandé par la sortie com1.

Les transistors cascodes des commutateurs reçoivent comme tension de grille, une tension de référence des transistors cascodes du translateur, pour être passants en toutes circonstances. Dans l'exemple, les transistors cascodes 211 (MOS P) et 221 (MOS N) reçoivent sur leur grille la tension de référence V_{REFₚ}.

Ainsi, lorsque la tension d'alimentation Vdd est commutée sur le noeud N, aucun élément du commutateur 21 ne voit une trop haute tension à ses bornes. Inversement, lorsque la haute tension HV est commutée sur le noeud N, aucun élément du commutateur 22 ne voit une trop haute tension à ses bornes.

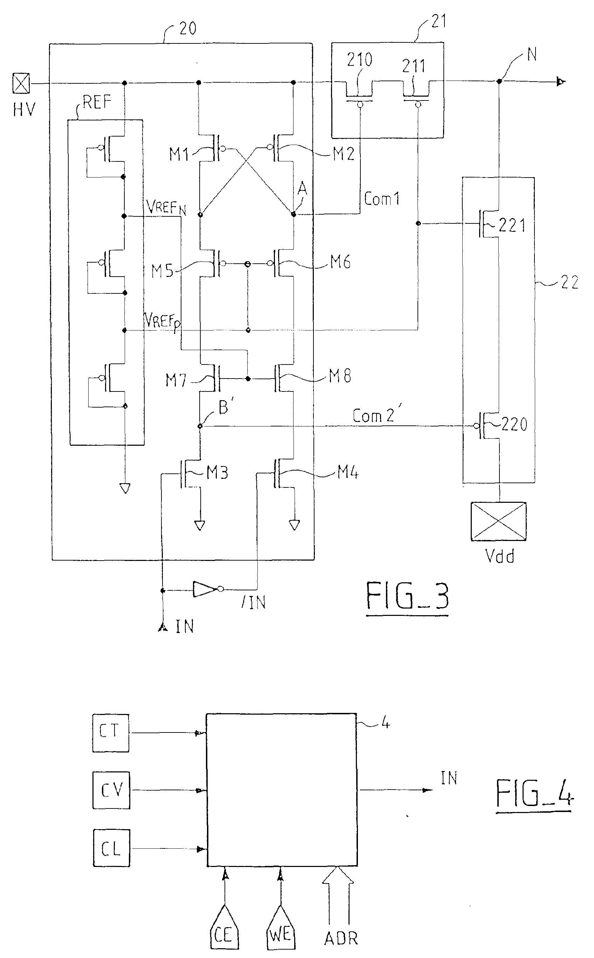

Dans l'exemple de réalisation représenté à la figure 2, le transistor 220 du commutateur 22 est un transistor de type N. Dans une variante représentée à la figure 3,c'est un transistor de type P. Le deuxième signal de commutation est alors pris dans l'autre branche, entre le transistor M3 connecté à la masse et le transistor cascode précédent, M7 dans l'exemple. Ce signal de commutation est noté com2' sur la figure 3.

Si on reprend la réalisation représentée à la figure 2, lorsque le signal d'alarme IN est à son niveau actif, correspondant dans l'exemple à l'état bas "0", le premier signal de commutation com1 s'établit à la limite basse imposée le transistor cascode M6, soit V_{REF_{P-}}+Vt. Cela rend passant le transistor de commutation 210. Le deuxième signal de commutation com2 est tiré à la masse par le transistor M4 passant. Le transistor de commutation 220 est bloqué. La haute tension HV est commutée sur le noeud N.

Lorsque le signal d'alarme IN est à son niveau inactif, correspondant dans l'exemple à l'état haut "1", c'est le transistor M3 qui devient passant. Le premier signal de commutation com1 remonte pour s'établir à HV (5 volts). Le transistor de commutation M210 est donc complètement bloqué. Le deuxième signal de commutation monte à un niveau haut de l'ordre de V_{REF_{N}}-Vtₙ, limite imposée par le transistor cascode M8 et qui doit être supérieure à Vdd+Vtₙ. En pratique, il suffit d'une tension de grille légèrement supérieure à sa tension de source (Vdd) pour rendre passant le transistor M220. Ainsi, la tension d'alimentation logique Vdd est commutée sur le noeud N.

Dans les deux cas, IN à "1" et IN à "0", les niveaux de tension appliqués aux bornes (drain, source, grille) des transistors des commutateurs 21 et 22 sont tels que ces transistors ne sont jamais stressés, et n'ont pas de fuites de courant, assurant la fiabilité du dispositif de protection selon l'invention.

En pratique, les valeurs du niveau bas du premier signal de commutation et du niveau haut du deuxième signal de commutation sont obtenues en dimensionnant de façon appropriée les transistors du circuit de référence des transistors cascodes. Dans l'exemple, avec HV à 5 volts et Vdd à 1,8 volts, il faut dimensionner le circuit de référence pour que V_{REF_{P_}}+Vt soit inférieur à Vdd-(Vtₚ+Vbe) où Vbe représente l'effet substrat, soit en pratique inférieur à environ 4 volts, et V_{REF_{N}} -Vt supérieur à Vdd+Vtₙ, soit environ 2,3 volts (pour Vdd=1,8 volts).

Sur la figure 4, on a représenté de façon schématique des moyens 4 de détection d'anomalies, qui génèrent en sortie le signal d'alarme IN.

Dans l'exemple, ces moyens de détection reçoivent des signaux de contrôle du circuit intégré, comme typiquement les signaux de sélection CE et d'écriture WE et les signaux d'adresse ADR, et la sortie de capteurs, et détecteurs logiciels. On peut avoir comme capteurs, un capteur de température CT, un capteur de tension CV, qui vérifie le niveau de la tension d'alimentation logique Vdd, un capteur de lumière CL.....Comme détecteurs logiciels, on pourra avoir un détecteur d'anomalie sur les accès, sur l'utilisation du jeu d'instructions, ...

En pratique, tout ou partie des vérifications des capteurs et détecteurs peuvent être assurés par un microprocesseur (le microprocesseur du circuit intégré), pour générer un signal d'alarme à partir de critères définis.

L'invention ne se limite pas aux exemples particuliers de mise en oeuvre ou de réalisation décrits. Il existe notamment de nombreuses variantes pratiques de translateurs, applicables au dispositif de protection selon l'invention. La sélection des éléments logiques qui seront alimentés par un dispositif de protection selon l'invention dépend en pratique du circuit intégré considéré et de son application.

## Revendications

1. Circuit intégré (1) ayant comme tensions d'alimentation, une tension de référence de masse (Gnd), une tension d'alimentation logique (Vdd), et une haute tension (HV), **caractérisé en ce qu'**il comprend en outre un dispositif de protection (2) associé à au moins un élément de circuit, à oxyde de grille, pour appliquer sur un noeud (N) d'alimentation dudit élément, soit la tension d'alimentation logique (Vdd), dans des conditions normales de fonctionnement du circuit intégré, soit la haute tension (HV), dans des conditions anormales de fonctionnement du circuit intégré, pour claquer l'oxyde de grille afin de rendre irréversiblement inutilisable ledit circuit intégré.

2. Circuit intégré selon la revendication 1, comprenant des moyens (4) de vérification des conditions normales de fonctionnement du circuit intégré pour activer le cas échéant un signal d'alarme (IN), **caractérisé en ce que** ledit signal d'alarme (IN) est appliqué en entrée de commande du dispositif de protection (2).

3. Circuit intégré selon la revendication 1 ou 2, **caractérisé en ce que** le dispositif de protection (2) comprend un premier commutateur (21) pour appliquer la haute tension (HV) sur ledit noeud (N) d'alimentation et un deuxième commutateur (22) pour appliquer la tension d'alimentation logique (Vdd) sur ledit noeud d'alimentation, lesdits commutateurs fonctionnant de façon complémentaire.

4. Circuit intégré selon la revendication 2 en combinaison avec la revendication 3, **caractérisé en ce que** le dispositif de protection comprend un translateur de tension (20) à au moins un étage cascode (M4, M5, M6, M7), ledit translateur étant connecté entre la haute tension (HV) et la tension de référence de masse électrique (Gnd), et commandé par ledit signal d'alarme (IN), pour fournir en sortie un signal de commande de commutation des commutateurs (21, 22).

5. Circuit intégré selon la revendication 4, le translateur comprenant dans chacune de ses deux branches, un transistor connecté à la haute tension (HV), un transistor connecté à la tension de référence de masse (Gnd) et au moins un transistor cascode entre ces deux transistors, **caractérisé en ce qu'**un premier signal de commande de commutation (com1) est pris dans une branche du translateur, entre le transistor(M2) connecté à la haute tension et le transistor cascode suivant (M6) et **en ce qu'**un deuxième signal de commutation (com2) est pris dans une branche, entre le transistor (M4) connecté à la masse et le transistor cascode précédent (M8).

6. Circuit intégré selon la revendication 5, **caractérisé en ce que** chaque commutateur (21) comprend un transistor cascode (211), connecté entre le dit noeud d'alimentation et le transistor (210) recevant un signal de commutation fourni par le translateur (20), ledit transistor cascode recevant sur sa grille une des tensions de référence des transistors cascode du translateur.

7. Circuit intégré selon l'une quelconque des revendications précédentes, **caractérisé en ce que** ledit noeud d'alimentation (N) est le noeud d'application de la tension d'alimentation logique à tout le circuit intégré.

8. Circuit intégré selon l'une quelconque des revendications précédentes, **caractérisé en ce que** la haute tension est appliquée sur une broche externe du circuit intégré.

9. Circuit intégré selon l'une quelconque des revendications précédentes, **caractérisé en ce que** la haute tension est fournie en interne à partir de la tension d'alimentation logique.

10. Procédé de protection d'un circuit intégré contre des utilisations anormales, ledit circuit intégré comprenant des moyens (4) pour détecter de telles utilisations anormales, **caractérisé en ce qu'**il consiste à appliquer une haute tension (HV) à la place d'une tension d'alimentation logique (Vdd), sur au moins un élément logique du circuit intégré, pour claquer l'oxyde de grille dudit élément, en sorte que le circuit intégré devienne irréversiblement inutilisable.
